# EUROPEAN PATENT APPLICATION

(11) **EP 4 471 847 A1**
(43) Date of publication of application: **04.12.2024**
(21) Application number: 23746660.2
(22) Date of filing: 12.01.2023
(51) Int. Cl.: H01L 23/36, H01L 21/3205, H01L 21/768, H01L 23/522, H01L 27/146

(54) **SEMICONDUCTOR DEVICE, METHOD FOR MANUFACTURING SAME, AND ELECTRONIC APPARATUS**

(30) Priority: 27.01.2022 JP 2022010942
(71) Applicant: Sony Semiconductor Solutions Corporation, Atsugi-shi, Kanagawa 243-0014 (JP)
(72) Inventor: GOCHO, Tetsuo, Atsugi-shi, Kanagawa 243-0014 (JP)
(74) Representative: D Young & Co LLP
(86) International application number: PCT/JP2023/000539
(87) International publication number: WO 2023/145445

(57) **Abstract**

The present disclosure relates to a semiconductor device, a method of manufacturing the same, and an electronic apparatus capable of providing a heat dissipation structure suitable for a CSP.

The semiconductor device includes a heat dissipation unit that penetrates a semiconductor layer and an insulating film formed on a first surface side of the semiconductor layer and protrudes from the insulating film to be exposed. The present disclosure can be applied to, for example, a semiconductor package in which a CMOS image sensor is packaged in a chip size, or the like.

## Description

### TECHNICAL FIELD

The present disclosure relates to a semiconductor device, a method of manufacturing the same, and an electronic apparatus, and more particularly to a semiconductor device, a method of manufacturing the same, and an electronic apparatus capable of providing a heat dissipation structure suitable for a CSP.

### BACKGROUND ART

In recent years, the amount of data processed by a semiconductor device is increasing progressively, and the amount of heat generated by a semiconductor device is increasing with handling of higher-speed and larger-capacity information. Furthermore, as the degree of integration in a chip is improved by miniaturization, the thermal density of a semiconductor device is also increased. Although various heat dissipation structures have been proposed as heat dissipation means of a semiconductor chip (see, for example, Patent Document 1), a heat dissipation fin is often formed on the upper surface side or the lower surface side of the chip in general (see, for example, Patent Document 2).

### CITATION LIST

### PATENT DOCUMENT

Patent Document 1: Japanese Patent Application Laid-Open No. 2011-249563
Patent Document 2: Japanese Patent Application Laid-Open No. 2008-218561

### SUMMARY OF THE INVENTION

### PROBLEMS TO BE SOLVED BY THE INVENTION

A chip size package (CSP) also requires a heat dissipation structure such as a fin that is often used conventionally.

The present disclosure has been made in view of such a situation, and an object thereof is to provide a heat dissipation structure suitable for a CSP.

### SOLUTIONS TO PROBLEMS

A semiconductor device according to a first aspect of the present disclosure includes a heat dissipation unit that penetrates a semiconductor layer and an insulating film formed on a first surface side of the semiconductor layer and protrudes from the insulating film to be exposed.

A method of manufacturing a semiconductor device according to a second aspect of the present disclosure includes forming a heat dissipation unit that penetrates a semiconductor layer and an insulating film formed on a first surface side of the semiconductor layer and protrudes from the insulating film to be exposed.

An electronic apparatus according to a third aspect of the present disclosure includes a semiconductor device including a heat dissipation unit that penetrates a semiconductor layer and an insulating film formed on a first surface side of the semiconductor layer and protrudes from the insulating film to be exposed.

In the first to third aspects of the present disclosure, a heat dissipation unit, which penetrates a semiconductor layer and an insulating film formed on a first surface side of the semiconductor layer and protrudes from the insulating film to be exposed, is formed.

The semiconductor device and the electronic apparatus may be independent devices, or modules incorporated in other devices.

### BRIEF DESCRIPTION OF DRAWINGS

Fig. 1 is a cross-sectional view and a plan view of a solid-state imaging device as a first embodiment of the present disclosure.
Fig. 2 is a cross-sectional view illustrating a detailed configuration example of a main body in Fig. 1.
Fig. 3 is a diagram for explaining a method of manufacturing the solid-state imaging device of the first embodiment.
Fig. 4 is a diagram for explaining the method of manufacturing the solid-state imaging device of the first embodiment.
Fig. 5 is a diagram for explaining the method of manufacturing the solid-state imaging device of the first embodiment.
Fig. 6 is a cross-sectional view and a plan view illustrating a modification of the solid-state imaging device of the first embodiment.
Fig. 7 is a cross-sectional view and a plan view illustrating a modification of the solid-state imaging device of the first embodiment.
Fig. 8 is a cross-sectional view of a semiconductor device as a second embodiment of the present disclosure.
Fig. 9 is a cross-sectional view and a plan view illustrating a detailed configuration example of a main body in Fig. 8.
Fig. 10 is a plan view and a perspective view of a back surface side of a second circuit board.
Fig. 11 is a view for explaining a method of manufacturing the semiconductor device of the second embodiment.
Fig. 12 is a view for explaining a variation of a structure of a heat dissipation unit.
Fig. 13 is a view for explaining a variation of a structure of a heat dissipation unit.
Fig. 14 is a view for explaining a variation of a structure of a heat dissipation unit.
Fig. 15 is a view for explaining a variation of a structure of a heat dissipation unit.
Fig. 16 is a view for explaining an effect of a heat dissipation unit.
Fig. 17 is a cross-sectional view and a plan view of a main body of a semiconductor device as a third embodiment of the present disclosure.
Fig. 18 is a cross-sectional view and a plan view of a modification of the third embodiment of the present disclosure.
Fig. 19 is a view for explaining an effect of using a high thermal conductivity material as a material of a heat dissipation unit.
Fig. 20 is a block diagram illustrating a configuration example of an imaging device as an electronic apparatus to which the technology of the present disclosure is applied.
Fig. 21 is a view for explaining a usage example of an image sensor.
Fig. 22 is a block diagram illustrating an example of a schematic configuration of a vehicle control system.
Fig. 23 is an explanatory diagram illustrating an example of installation positions of an outside-vehicle information detection unit and an imaging section.

### MODE FOR CARRYING OUT THE INVENTION

Hereinafter, modes for carrying out the technique of the present disclosure (which will be hereinafter referred to as embodiments) will be described with reference to the accompanying drawings. Explanation will be made in the following order.
1. Schematic configuration of first embodiment
2. Detailed configuration example of main body of first embodiment
3. Method of manufacturing solid-state imaging device of first embodiment
4. Modification of solid-state imaging device
5. Schematic configuration of second embodiment
6. Detailed configuration example of main body of second embodiment
7. Method of manufacturing semiconductor device of second embodiment
8. Variation of structure of heat dissipation unit
9. Configuration example of third embodiment
10. Example of application to electronic apparatus
11. Usage example of image sensor
12. Example of application to mobile body

Note that, in the drawings referred to in the following description, the same or similar parts are denoted by the same or similar reference signs, and redundant description will be omitted as appropriate. The drawings are schematic, and the relationship between the thickness and the plane dimension, the ratio of the thickness of each layer, and the like are different from the actual ones. Furthermore, the drawings may include parts having different dimensional relationships and ratios.

Furthermore, definition of directions such as upward and downward directions, and the like in the following description is merely the definition for convenience of description, and does not limit the technical idea of the present disclosure. For example, when an object is rotated by 90° to be observed, the upper and lower sides are changed as the left and right sides, and when the object is rotated by 180° to be observed, the upper and lower sides are inverted.

### <1. Schematic configuration of first embodiment>

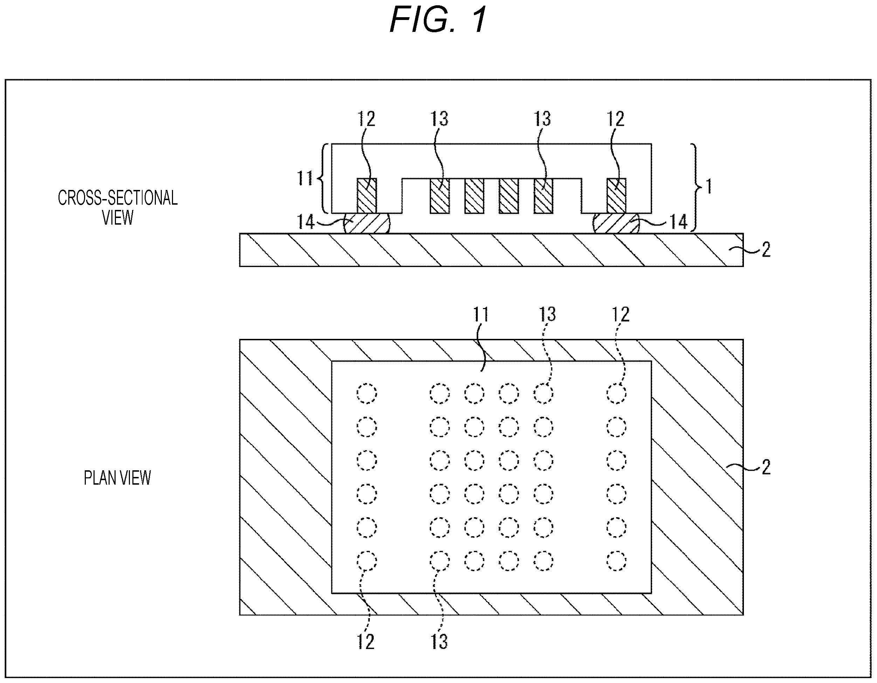

Fig. 1 is a cross-sectional view and a plan view of a solid-state imaging device as a first embodiment of the present disclosure.

A solid-state imaging device 1 in Fig. 1 has a main body 11, a plurality of through electrodes 12, a plurality of heat dissipation units 13, and a plurality of electrode units 14, captures light (incident light) from a subject, generates an image signal, and outputs the image signal to an interposer substrate 2. The solid-state imaging device 1 is a chip size package (CSP) packaged in a chip size.

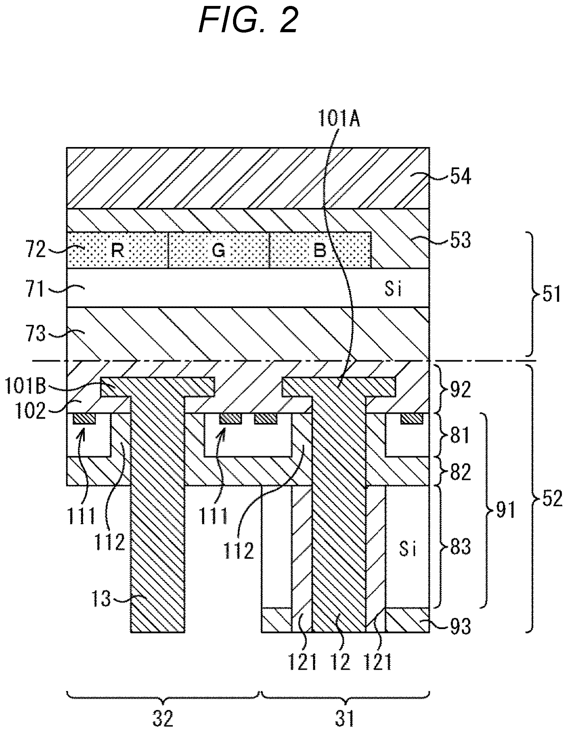

The main body 11 includes a laminated substrate of a first substrate and a second substrate, which will be described later in detail with reference to Fig. 2 and the like. The main body 11 has different thicknesses between a part where the through electrodes 12 are formed and a part where the heat dissipation units 13 are formed.

Each through electrode 12 is connected with an electrode unit 14, which is an external terminal, and exchanges signals with the interposer substrate 2 via the electrode unit 14 and receives supply of a power supply voltage.

Note that the connection partner to be electrically connected with the solid-state imaging device 1 via the electrode units 14 may be a device other than the interposer substrate 2, for example, a semiconductor chip.

The heat dissipation units 13 are formed in a part of the main body 11 thinner than the part where the through electrodes 12 are formed, and dissipates (heat dissipation) heat generated in the main body 11 from a part protruding from the main body 11 to be exposed. The heat dissipation units 13 are formed using, for example, a metal material having high thermal conductivity such as copper (Cu) or tungsten (W). The through electrodes 12 also include the same metal material as the heat dissipation units 13.

The plan view of Fig. 1 is a view of the solid-state imaging device 1 and the interposer substrate 2 obtained by viewing the cross-sectional view from above, and the through electrodes 12 and the heat dissipation units 13 disposed on the lower surface of the main body 11 are shown by broken lines in the main body 11.

The solid-state imaging device 1 has the plurality of through electrodes 12 and the plurality of heat dissipation units 13, and the through electrodes 12 and the heat dissipation units 13 each have a pillar shape (columnar shape) as a three-dimensional shape. Although the through electrodes 12 and the heat dissipation units 13 are arranged in a matrix at equal intervals in the example in Fig. 1, the arrangement of the through electrodes 12 and the heat dissipation units 13 is not limited thereto.

### <2. Detailed configuration example of main body of first embodiment>

Fig. 2 is a cross-sectional view illustrating a detailed configuration example of the main body 11 in Fig. 1.

Fig. 2 is a cross-sectional view illustrating a through electrode region 31 where the through electrodes 12 are formed and a heat dissipation unit region 32 where the heat dissipation units 13 are formed, which are part of the main body 11, adjacent to each other for the sake of convenience.

The main body 11 is formed by laminating a CIS substrate 51 as a first substrate and a logic substrate 52 as a second substrate. A dashed-dotted line in Fig. 2 indicates a bonding surface between the CIS substrate 51 and the logic substrate 52.

The CIS substrate 51 is a substrate including a pixel array unit in which pixels having photodiodes that receive incident light and perform photoelectric conversion are two-dimensionally arranged in a matrix. The logic substrate 52 is a substrate including a logic circuit that performs predetermined signal processing using a signal generated in each pixel of the CIS substrate 51. A glass protective substrate 54 is connected with an upper portion of the CIS substrate 51, to which incident light enters, via a sealing resin 53 in a cavity-less structure.

The CIS substrate 51 includes a semiconductor substrate 71 using, for example, silicon (Si) as a semiconductor material, and a color filter layer 72 is formed on the light incident surface side of the semiconductor substrate 71. On the semiconductor substrate 71, photodiodes as photoelectric conversion units are formed in pixel units, and in the color filter layer 72, R (red), G (green), or B (blue) color filters are arranged in predetermined arrangement such as Bayer arrangement in pixel units. The photodiode of each pixel photoelectrically converts R, G, or B light that enters through the color filter layer 72. The upper surface of the semiconductor substrate 71 on which the color filter layer 72 is formed is the back surface of the semiconductor substrate 71, and the solid-state imaging device 1 is a back-illuminated type CMOS image sensor. At least an insulating film 73 is formed on the lower surface of the semiconductor substrate 71, and one or more layers of metal wiring may be formed as necessary.

The logic substrate 52 has an SOI substrate 91 in which a semiconductor layer 81, an insulating film 82, and a semiconductor substrate 83 are laminated. In the SOI substrate 91, the semiconductor layer 81 is disposed in an upper layer closest to the CIS substrate 51, and the semiconductor substrate 83 is disposed in a lower layer of the electrode unit 14 (Fig. 1) side. The insulating film 82 is an intermediate layer between the semiconductor layer 81 and the semiconductor substrate 83, and includes, for example, a silicon oxide film (SiO2).

The semiconductor layer 81, the insulating film 82, and the semiconductor substrate 83 are laminated in the through electrode region 31 where the through electrodes 12 are formed, while the semiconductor layer 81 and the insulating film 82 are formed and the semiconductor substrate 83 is not formed in the heat dissipation unit region 32 where the heat dissipation units 13 are formed. In Fig. 1, the thickness of the main body 11 different between a part where the through electrodes 12 are formed and a part where the heat dissipation units 13 are formed depends on the presence or absence of the semiconductor substrate 83.

The wiring layer 92 including one or more layers of metal wiring 101 (101A, 101B) and an interlayer insulating film 102 is formed on an upper (CIS substrate 51 side) surface of the semiconductor layer 81. An insulating film 93 is formed on a back surface (the lower surface in Fig. 2) of the semiconductor substrate 83 opposite to the surface on which the wiring layer 92 is formed.

The semiconductor layer 81 includes a silicon layer using, for example, silicon (Si) as a semiconductor material, and is isolated from the through electrodes 12 and the heat dissipation units 13 including a conductive material by the element isolation region 112. In the semiconductor layer 81, one or more elements 111 are formed at predetermined positions. The elements 111 formed in the semiconductor layer 81 are, for example, a pixel transistor (MOS FET), a capacitor element (MIM capacitor), or the like.

The through electrodes 12 are connected with a predetermined metal wiring 101A in the wiring layer 92, penetrates the semiconductor layer 81, the insulating film 82, and the semiconductor substrate 83, and are connected with the electrode units 14 (Fig. 1). The through electrodes 12 are isolated from the semiconductor layer 81 by an element isolation region 112, and is isolated from the semiconductor substrate 83 by an insulating film 121. The element isolation region 112 includes, for example, shallow trench isolation (STI), and the insulating film 121 includes, for example, a silicon oxide film, a silicon nitride film, a resin film, or the like.

The heat dissipation units 13 are connected with a predetermined metal wiring 101B in the wiring layer 92, penetrate the semiconductor layer 81 and the insulating film 82, and protrude from the insulating film 82 to be exposed. The heat dissipation units 13 are isolated from the semiconductor layer 81 by the element isolation region 112. The length of the heat dissipation units 13 (the length in the direction perpendicular to the planar direction of the semiconductor layer 81) is the same as that of the through electrodes 12, and the length of the exposed parts of the heat dissipation units 13 corresponds to the thickness of the semiconductor substrate 83 and the insulating film 93. Accordingly, the heat dissipation units 13 are exposed by at least the thickness of the semiconductor substrate 83.

The main body 11 of the solid-state imaging device 1 has the plurality of heat dissipation units 13 as described above, and the heat dissipation units 13 protrude from the insulating film 82 to be exposed by the same length as the through electrodes 12, so that the heat dissipation unit has a heat dissipation structure with excellent heat dissipation efficiency.

### <3. Method of manufacturing solid-state imaging device according to first embodiment>

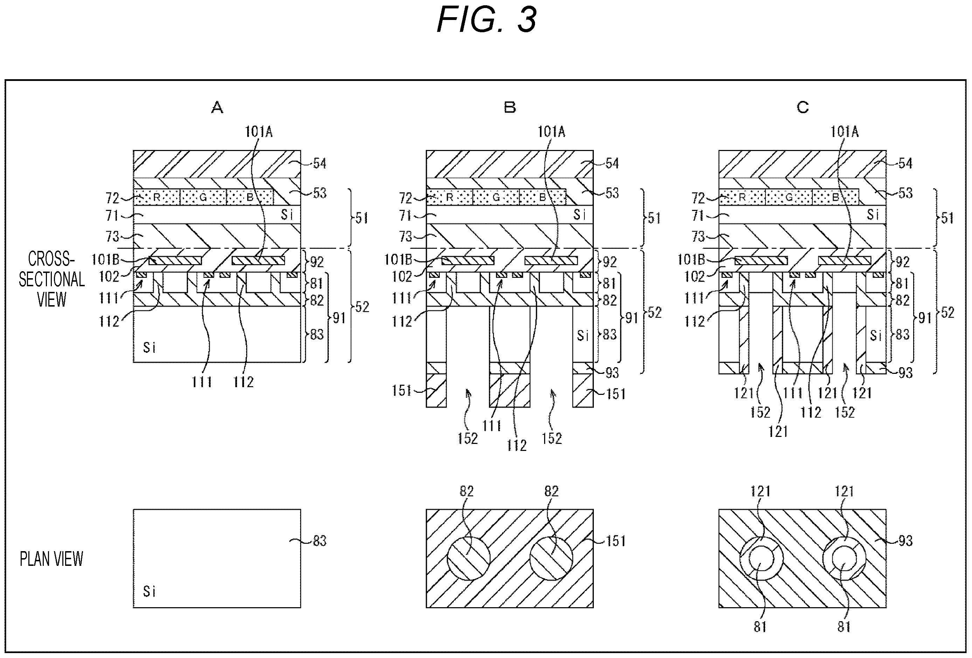

Next, a method of manufacturing the solid-state imaging device 1 of the first embodiment will be described with reference to Figs. 3 to 5. Figs. 3 to 5 each illustrate a cross-sectional view of a laminated structure of the CIS substrate 51 and the logic substrate 52, and a plan view of the laminated structure as viewed from the back surface side on which the electrode units 14 are formed.

A of Fig. 3 illustrates a state in which the wiring layer 92 on the front surface side of the SOI substrate 91 on which the elements 111 are formed, and the insulating film 73 of the CIS substrate 51 whose light incident surface side is protected by the glass protective substrate 54 are bonded.

Up to the state of A of Fig. 3, for example, manufacturing is performed as follows. One or more elements 111 are formed in the semiconductor layer 81 of the SOI substrate 91, and an STI is formed as an element isolation region 112 around the unit region where the elements 111 are formed for isolation. The STI may be formed so as to reach the insulating film 82, which is an intermediate layer of the SOI substrate 91, and may be formed so as to penetrate the insulating film 82 and reach the semiconductor substrate 83. Subsequently, the wiring layer 92 including one or more metal wirings 101 and the interlayer insulating film 102 is formed on the upper side of the semiconductor layer 81. Then, the insulating film 73 formed on one surface of the separately manufactured CIS substrate 51, and the interlayer insulating film 102 of the wiring layer 92 are bonded by oxide film bonding. The glass protective substrate 54 is connected with a surface of a separately manufactured CIS substrate 51 opposite to the insulating film 73 by the sealing resin 53.

Next, as illustrated in B of Fig. 3, the insulating film 93 is formed on the entire back surface side of the semiconductor substrate 83 by using, for example, a CVD method or the like. The insulating film 93 is, for example, a silicon oxide film (SiO2). Subsequently, a resist 151 is patterned on the upper surface of the insulating film 93 so as to open the positions where the through electrodes 12 and the heat dissipation units 13 are formed, and etched until reaching the insulating film 82, thereby forming through holes 152 penetrating the semiconductor substrate 83. After the through holes 152 are formed, the resist 151 is removed.

Next, as illustrated in C of Fig. 3, after the insulating film 121 serving as a sidewall is formed on a sidewall of the through holes 152, the insulating film 82 at a bottom portion (upper portion in the figure) of the through holes 152 is etched. The insulating film 121 on the sidewall of the through holes 152 can be formed by, for example, forming a silicon oxide film (SiO2), a silicon nitride film (SiN), or the like by a CVD method or the like, and then performing etchback.

Note that the insulating film 121 can include a resin film instead of a silicon oxide film, a silicon nitride film, or the like. As the resin material in that case, for example, a base resin having a carboxylic acid, an inorganic filler, an epoxy resin, or a material including a pigment can be used, and as the base resin, a cyclized polyisoprene or a cyclized polybutadiene obtained by cyclizing polyisoprene or polybutadiene with an acid catalyst, a novolac resin and a 1,2-naphthoquinonediazidesulfonic acid ester-based compound, polyvinyl cinnamate, an epoxy resin, polysiloxane, polyamideimide, polyoxazole, polyacrylamide, cresol novolac, polyisoprene, polyvinyl alcohol, or the like can be used.

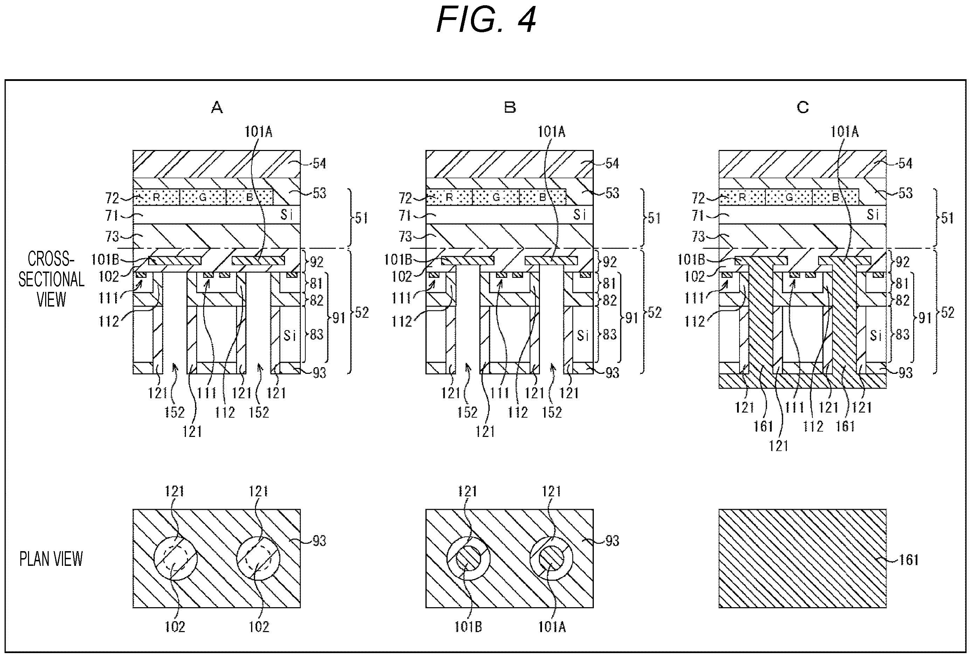

Next, as illustrated in A of Fig. 4, the semiconductor layer 81 at the bottom portion (upper portion in the figure) of the through holes 152 is removed by etching. For etching of the semiconductor layer 81, for example, wet etching using an alkaline solution such as KOH (potassium hydroxide) in which the interlayer insulating film 102 including a silicon oxide film is not etched, chemical dry etching in which etching is performed by microwave plasma using, for example, XeF2 gas, or the like can be adopted.

Next, as illustrated in B of Fig. 4, the interlayer insulating film 102 of the wiring layer 92 is removed by dry etching or the like until reaching the metal wiring 101 closest to the semiconductor layer 81.

Next, as illustrated in C of Fig. 4, a predetermined metal material 161, for example, copper is embedded in the through holes 152 using, for example, an electrolytic plating method or the like, and the metal material 161 is also formed on the insulating film 93 on the back surface of the semiconductor substrate 83.

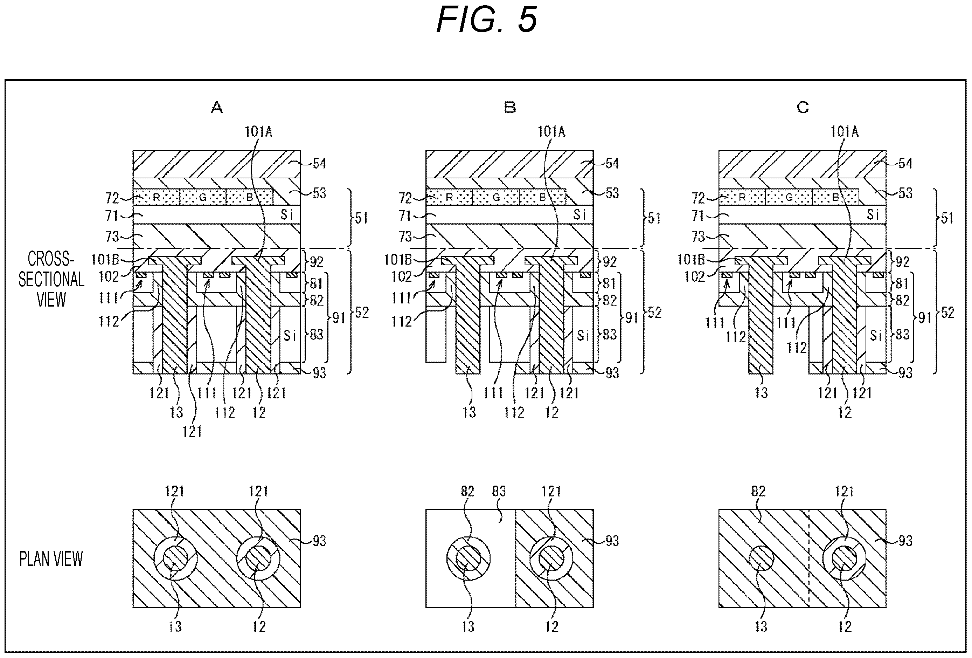

Then, as illustrated in A of Fig. 5, the metal material 161 on the back surface of the semiconductor substrate 83 is removed by chemical mechanical polishing (CMP), and the metal material 161 is left only in the through holes 152, so that the through electrodes 12 and the heat dissipation units 13 are formed.

Next, as illustrated in B of Fig. 5, by patterning and etching a resist (not illustrated) in the through electrode region 31 where the through electrodes 12 are formed and on the upper surface (lower surface in Fig. 5) of the heat dissipation units 13, the insulating film 93 and the insulating film 121 in the heat dissipation unit region 32 are removed. After the insulating film 93 and the insulating film 121 are etched, the resist is removed. In a case where the insulating film 121 includes a resin film, the resist 162 can be removed by etching using a solvent, ashing with oxygen plasma, or ashing with ozone. As the solvent, for example, diethylene glycol monobutyl ether acetate, ethyl di-YUKIZOL acetate, butyl di-YUKIZOL acetate, tetramethylammonium hydroxide, tetramethylammonium hydroxide, tetrabutylammonium hydroxide, or the like can be used.

Next, as illustrated in C of Fig. 5, the semiconductor substrate 83 in the heat dissipation unit region 32 is etched, so that the heat dissipation units 13 in which the upper side (the lower side in Fig. 5) of the insulating film 82, which is the intermediate layer, is exposed are completed in the heat dissipation unit region 32. The state in C of Fig. 5 is the same as that of the main body 11 illustrated in Fig. 2.

As described above, the semiconductor layer 81 isolated by the element isolation region 112 and the insulating film 82 of the intermediate layer are etched from the back surface side of the logic substrate 52 on which the elements 111 are formed, the metal material 161 is embedded in the through holes 152 in which the insulating film 121 of the sidewall is formed, and then the semiconductor substrate 83 in the heat dissipation unit region 32 is removed, so that the heat dissipation units 13 can be formed. In a case where the semiconductor substrate 83 is not removed, the through electrodes 12 are formed, so that the through electrodes 12 and the heat dissipation units 13 can be formed simultaneously.

In the CSP, a structure in which the through electrodes 12 for taking out an electrode from the back surface side of the semiconductor substrate 83 are formed is adopted in order to downsize the chip. Since the heat dissipation units 13 of the solid-state imaging device 1 can be formed simultaneously with the through electrodes 12, a heat dissipation structure suitable for the CSP can be provided.

### <4. Modification of solid-state imaging device>

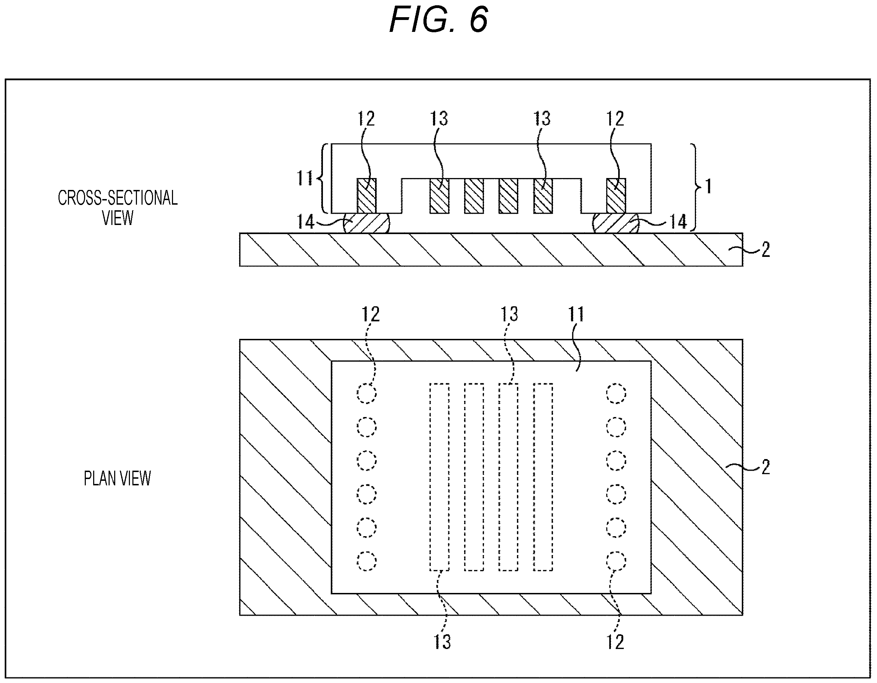

Fig. 6 is a cross-sectional view and a plan view illustrating a modification of the solid-state imaging device 1 illustrated in Fig. 1.

In the solid-state imaging device 1 illustrated in Fig. 1, the three-dimensional shape of the heat dissipation units 13 is the same pillar shape as that of the through electrodes 12.

On the other hand, in the solid-state imaging device 1 in Fig. 6 as a modification, the three-dimensional shape of the heat dissipation units 13 is a plate-shaped rectangular parallelepiped elongated in one direction of the longitudinal direction or the lateral direction in plan view. Although the arrangement direction of the plurality of through electrodes 12 and the extending direction of the plate-shaped heat dissipation units 13 are the same direction in the example in Fig. 6, the arrangement direction of the plurality of through electrodes 12 and the extending direction of the heat dissipation units 13 are not necessarily the same direction.

Since the solid-state imaging device 1 in Fig. 6 is configured similarly to the solid-state imaging device 1 in Fig. 1 except for the points described above, other description will be omitted.

Note that, although the plurality of through electrodes 12 is arranged in a peripheral portion close to an outer periphery of the rectangular main body 11 in plan view, and the plate-shaped heat dissipation units 13 are disposed in a central portion of the rectangular main body 11 in the solid-state imaging device 1 in Fig. 6, the arrangement of the through electrodes 12 and the heat dissipation units 13 is not limited thereto.

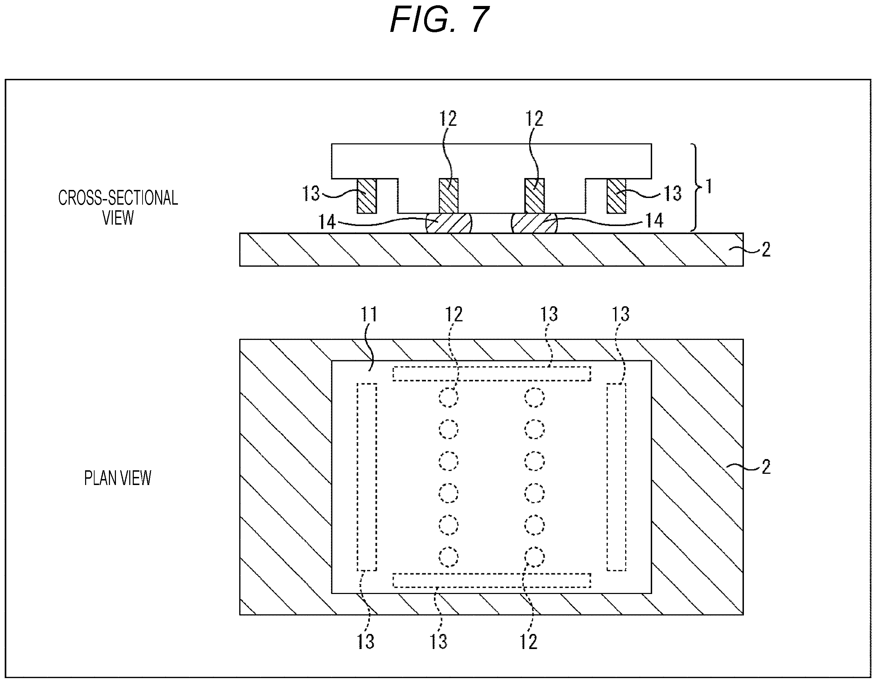

For example, as illustrated in Fig. 7, the plate-shaped heat dissipation units 13 may be disposed in a peripheral portion close to an outer periphery of the rectangular main body 11 in plan view, and the plurality of through electrodes 12 may be disposed in a central portion of the rectangular main body 11. The three-dimensional shape of the heat dissipation units 13 disposed in the peripheral portion may be a long plate-shaped rectangular parallelepiped, or may be a pillar shape similar to that of the solid-state imaging device 1 in Fig. 1.

### <5. Schematic configuration of second embodiment>

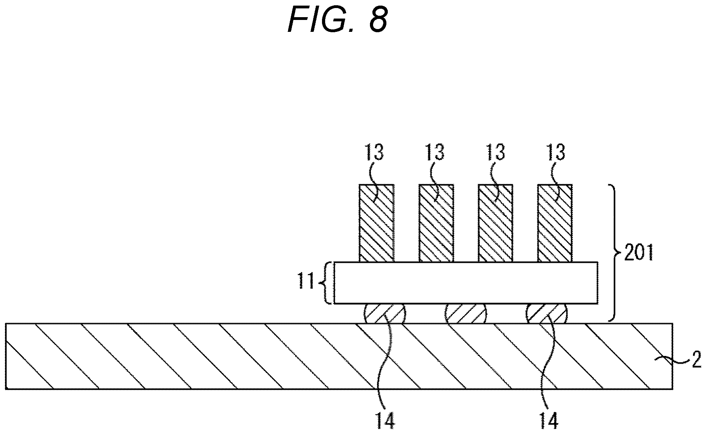

Fig. 8 is a cross-sectional view of a semiconductor device as the second embodiment of the present disclosure.

In the second embodiment in Fig. 8 and the following drawings, parts common with the above-described first embodiment are denoted by the same reference numerals, and the description of the parts will be omitted as appropriate.

Although an example in which the technology of the present disclosure is applied to a solid-state imaging device has been described in the first embodiment described above, the technology of the present disclosure is not limited to the solid-state imaging device, and can be applied to any semiconductor device.

A semiconductor device 201 in Fig. 8 is electrically connected with an interposer substrate 2 via electrode units 14, similarly to the first embodiment illustrated in Fig. 1. However, although the heat dissipation units 13 in the solid-state imaging device 1 in Fig. 1 are formed on the same surface of the main body 11 as the surface where the electrode units 14 are formed, heat dissipation units 13 in the semiconductor device 201 in Fig. 8 are formed on a surface of a main body 11 opposite to the surface where the electrode units 14 are formed. That is, the plurality of heat dissipation units 13 is formed on the upper surface of the main body 11, and the plurality of electrode units 14 is formed on the lower surface of the main body 11.

### <6. Detailed configuration example of main body of second embodiment>

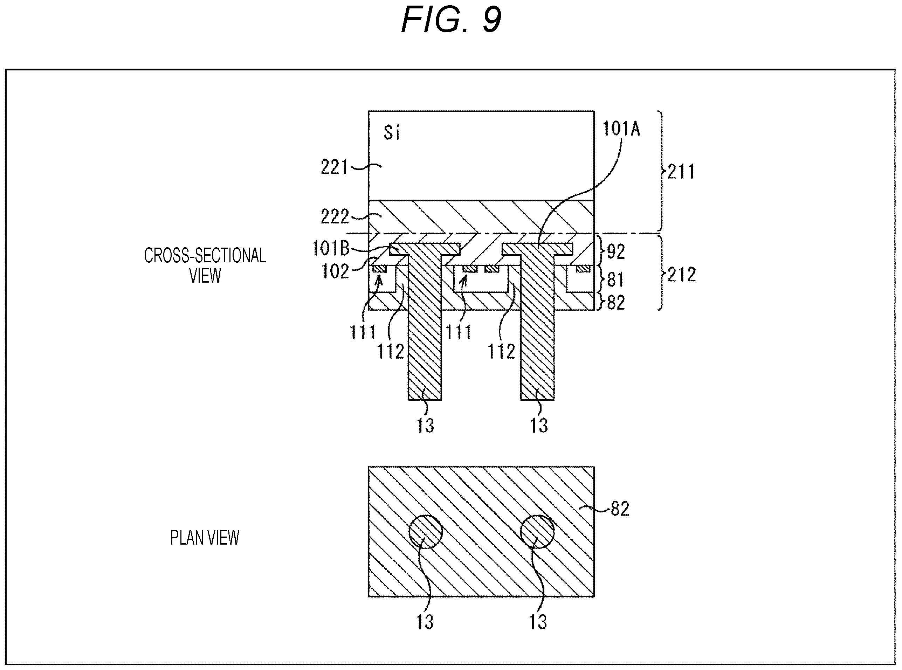

Fig. 9 is a cross-sectional view and a plan view illustrating a detailed configuration example of the main body 11 in Fig. 8.

In the cross-sectional view of Fig. 9, the heat dissipation units 13 protrude downward from the main body 11 to be exposed, and are vertically inverted from the main body 11 in Fig. 8. The plan view is a view of the laminated structure of the main body 11 as viewed from the lower side where the heat dissipation units 13 are formed.

The main body 11 is formed by laminating a first circuit board 211 as a first substrate and a second circuit board 212 as a second substrate.

The first circuit board 211 includes a semiconductor substrate 221 using, for example, silicon (Si) as a semiconductor material, and is bonded to the second circuit board 212 via an insulating film 222 formed on a lower surface of the semiconductor substrate 221. The electrode units 14 (Fig. 8), which are external terminals, are formed on an upper surface of the semiconductor substrate 221.

The second circuit board 212 is configured in a manner similar to that of the heat dissipation unit region 32 of the logic substrate 52 of the first embodiment, and a wiring layer 92 of the second circuit board 212 is bonded to the insulating film 222 of the first circuit board 211 by oxide film bonding. The second circuit board 212 includes a semiconductor layer 81, an insulating film 82, and the wiring layer 92 formed on the upper side of the semiconductor layer 81. The heat dissipation units 13 protrude from the insulating film 82 to be exposed. The three-dimensional shape of the heat dissipation units 13 is a pillar shape, similarly to the first embodiment in Fig. 1.

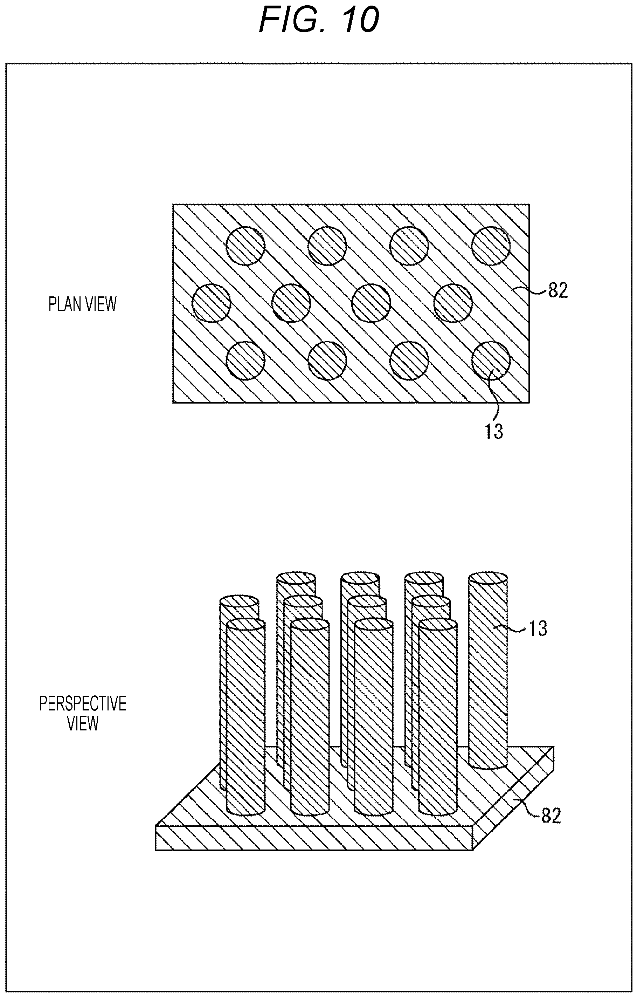

Fig. 10 illustrates a plan view and a perspective view of the back surface side of the second circuit board 212 in which the heat dissipation units 13 are exposed.

On the back surface side of the second circuit board 212, the plurality of heat dissipation units 13 is arranged in a predetermined arrangement, for example, shifted by a half pitch between an even column and an odd column and between an even row and an odd row as illustrated in Fig. 10. One heat dissipation unit 13 is formed in a pillar shape, a diameter of the circle is, for example, 10 um, and a length (height) of a part protruding from the insulating film 82 is, for example, 100 um. Note that the heat dissipation units 13 may be arranged in a matrix or randomly.

### <7. Method of manufacturing semiconductor device of second embodiment>

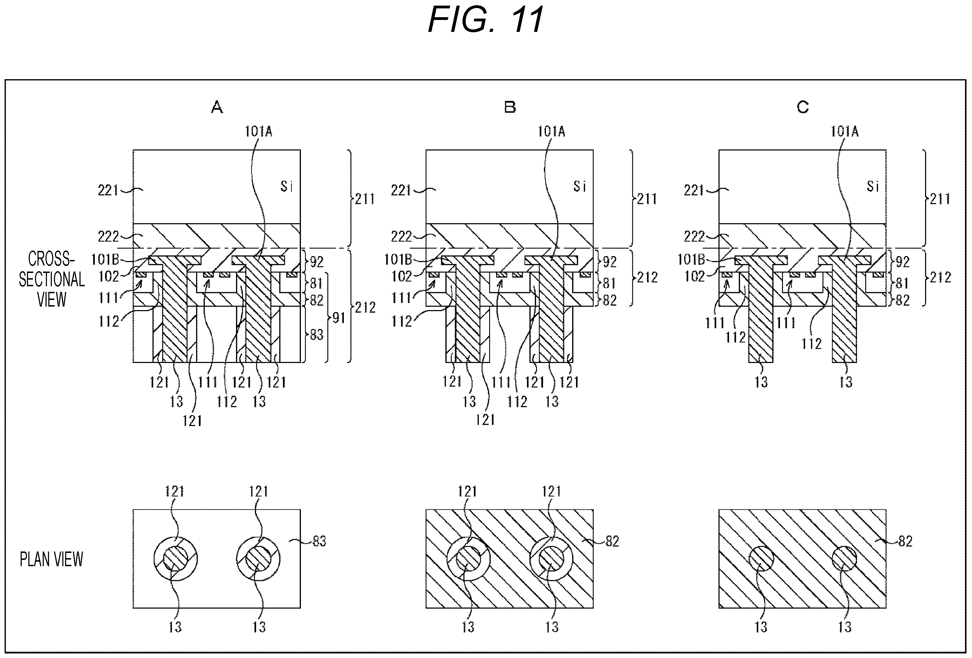

A method of manufacturing the semiconductor device 201 of the second embodiment will be described with reference to Fig. 11.

The semiconductor device 201 of the second embodiment is manufactured in a manner similar to that of the first embodiment until the steps described with reference to A of Fig. 3 to C of Fig. 4 in the first embodiment, except that the substrate on the upper side of the main body 11 of the laminated structure is changed from the CIS substrate 51 to the first circuit board 211.

By carrying out the steps from A of Fig. 3 to C of Fig. 4, manufacture is proceeded until the state of C of Fig. 4, specifically, a state in which the metal material 161 (e.g., copper) is embedded in the through holes 152 and the metal material 161 is formed on the insulating film 93 on the back surface of the semiconductor substrate 83.

By removing the metal material 161 and the insulating film 93 on the back surface of the semiconductor substrate 83 from the state of C in Fig. 4 using CMP, the back surface of the semiconductor substrate 83 is exposed as illustrated in A of Fig. 11.

Next, as illustrated in B of Fig. 11, the semiconductor substrate 83 is removed by, for example, wet etching.

Next, as illustrated in C of Fig. 11, the insulating films 121 formed around the lower heat dissipation units 13 are removed from the insulating film 82 by etching, and the main body 11 of the semiconductor device 201 illustrated in Fig. 9 is completed.

Although the semiconductor substrate 83 is first removed in the step of B in Fig. 11 and then the insulating film 121 formed around the heat dissipation units 13 is removed in the step of C in Fig. 11 in the above-described manufacturing method, the order of removing the semiconductor substrate 83 and the insulating film 121 may be reversed. That is, the semiconductor substrate 83 may be removed after first removing the insulating film 121 formed around the heat dissipation units 13. The point that the insulating film 121 may include a silicon oxide film, a silicon nitride film, or the like, or may include a resin film is similar to the first embodiment described above.

### <8. Variations of structure of heat dissipation unit>

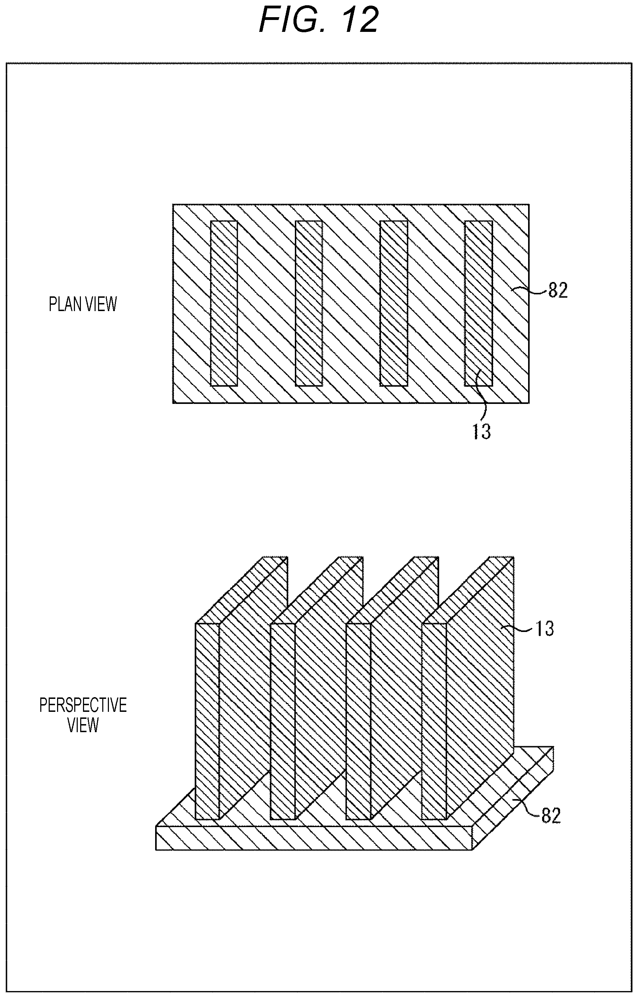

Next, another structure example of the heat dissipation units 13 will be described with reference to Figs. 12 to 15. In Figs. 12 to 15, a plan view and a perspective view of the back surface side of the second circuit board 212 are illustrated similarly to Fig. 10.

Fig. 12 illustrates an example in which the plurality of heat dissipation units 13 is arranged at equal pitches with the three-dimensional shape of the heat dissipation units 13 being a plate-shaped rectangular parallelepiped elongated in one direction of the longitudinal direction or the lateral direction in plan view. The size of the rectangular parallelepiped of the part protruding from the insulating film 82 of each heat dissipation unit 13 is such that the length in the longitudinal direction x the length in the lateral direction x the height (the length of the protruding part) is, for example, 2 mm x 10 um x 100 um.

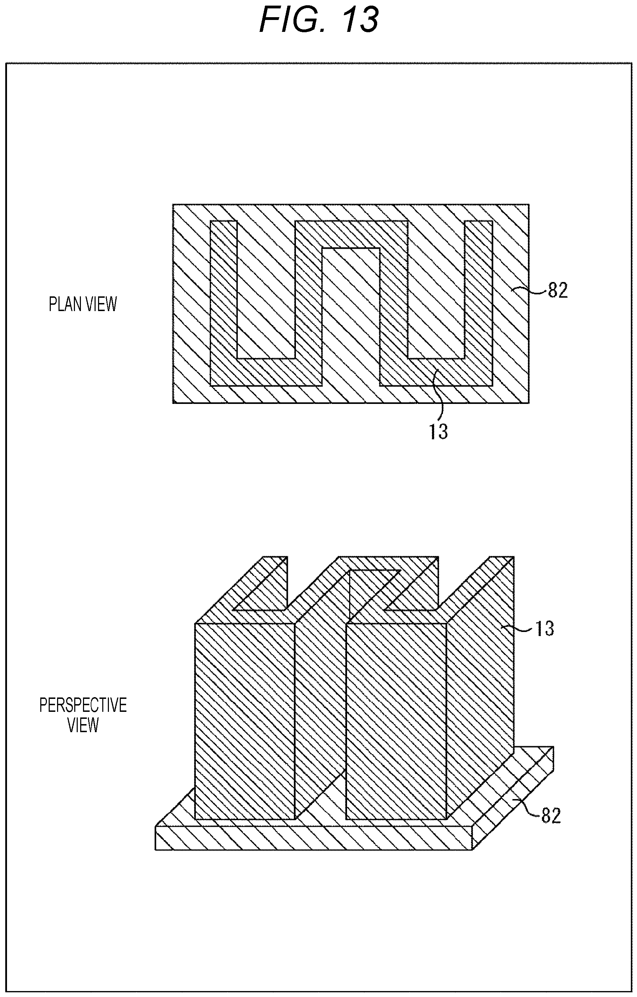

Fig. 13 illustrates an example in which the heat dissipation units 13 are formed to have a three-dimensional shape of a snake shape in which plate-shaped rectangular parallelepipeds elongated in the longitudinal direction and plate-shaped rectangular parallelepipeds elongated in the lateral direction in plan view are alternately connected and arranged.

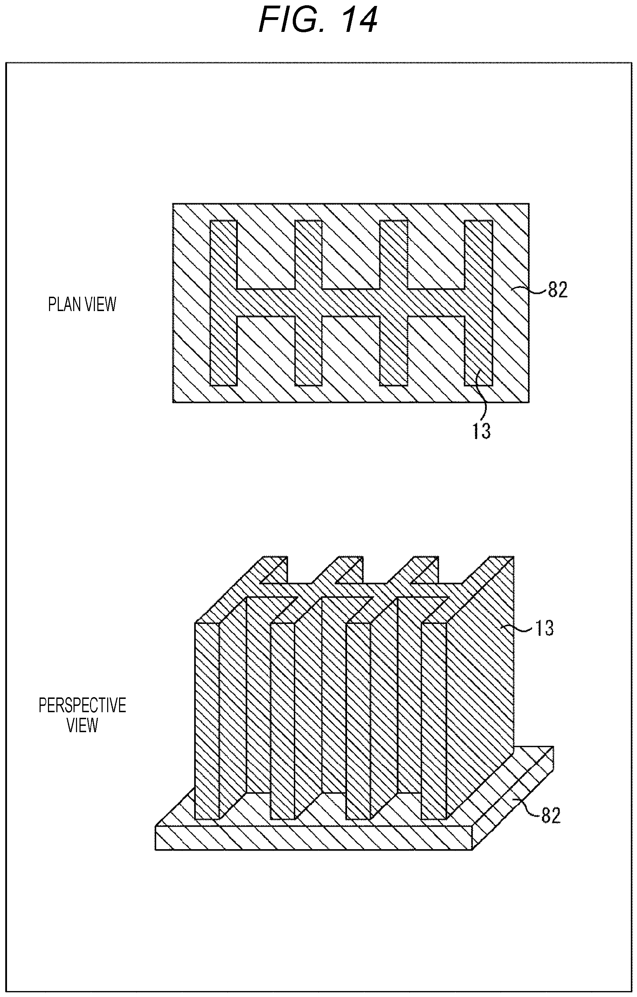

Fig. 14 illustrates an example in which the heat dissipation units 13 are formed to have a three-dimensional shape of a fishbone shape in which a plate-shaped rectangular parallelepiped elongated in one of the longitudinal direction and the lateral direction and a plurality of plate-shaped rectangular parallelepipeds elongated in the other direction intersect.

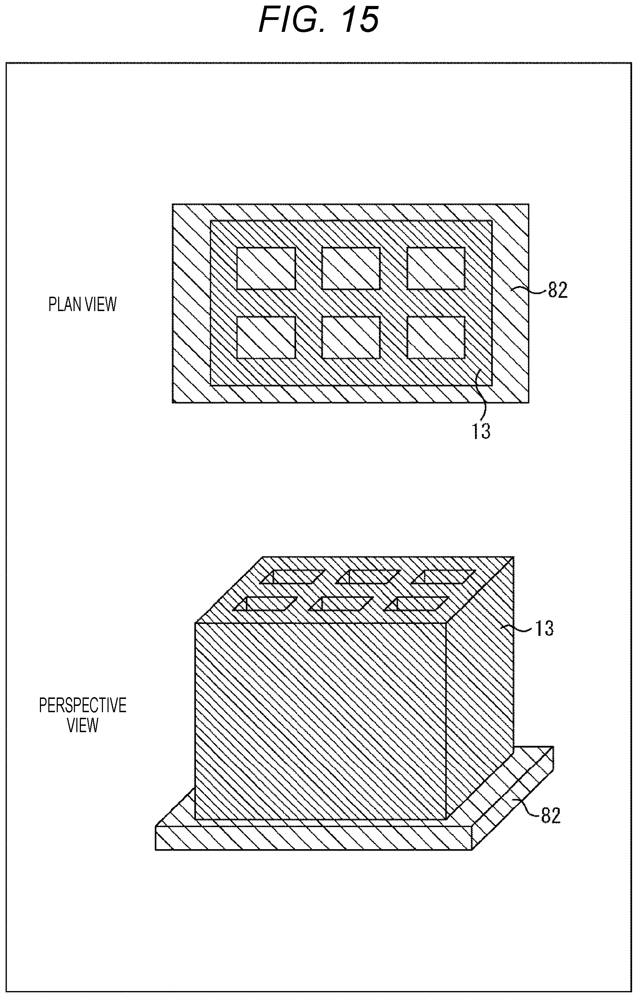

Fig. 15 illustrates an example in which the heat dissipation units 13 are formed to have a three-dimensional shape of a mesh shape in which a plurality of plate-shaped rectangular parallelepipeds elongated in the longitudinal direction and a plurality of plate-shaped rectangular parallelepipeds elongated in the lateral direction in plan view are arranged at a predetermined pitch.

The three-dimensional shapes of the snake shape in Fig. 13, the fishbone shape in Fig. 14, and the mesh shape in Fig. 15 each have a structure in which a plate-shaped rectangular parallelepiped elongated in the longitudinal direction and a plate-shaped rectangular parallelepiped elongated in the lateral direction in plan view are combined, and the structural strength is enhanced.

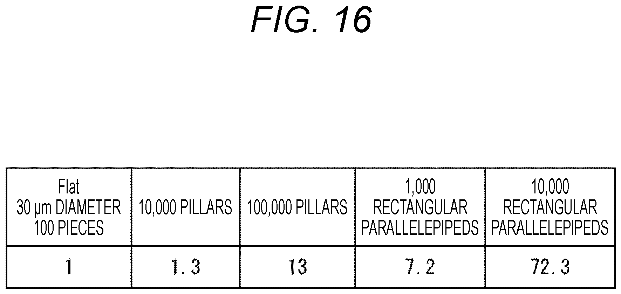

Fig. 16 is a table in which the surface areas of the pillar-shaped heat dissipation units 13 illustrated in Fig. 10 and the rectangular parallelepiped heat dissipation units 13 illustrated in Fig. 12 are compared with a case where there is no part of the heat dissipation units 13 protruding from the insulating film 82.

"Flat 30 um diameter, 100 pieces" represents a heat dissipation structure in which 100 circles having a diameter of 30 um are formed on the same plane as the insulating film 82 of the semiconductor device 201 of 5 mm square, and copper is embedded in the circles, and a surface area in this case is used as a reference ("1").

On the other hand, "10,000 pillars" represents a case where 10,000 pillar-shaped heat dissipation units 13 having a diameter of 10 um illustrated in Fig. 10 are arranged on the back surface of the semiconductor device 201 of 5 mm square, and the length (height) of the part protruding from the insulating film 82 is 100 um.

"100,000 pillars" represents a case where 100,000 pillar-shaped heat dissipation units 13 having a diameter of 10 um illustrated in Fig. 10 are arranged on the back surface of the semiconductor device 201 of 5 mm square, and the length (height) of the part protruding from the insulating film 82 is 100 um.

"1,000 rectangular parallelepipeds" represents a case where 1,000 heat dissipation units 13 having a plate-shaped rectangular parallelepiped shape illustrated in Fig. 12 and having a length in the longitudinal direction x a length in the lateral direction x a height (the length of a protruding part) of 2 mm x 10 um x 100 um are arranged on the back surface of the semiconductor device 201 of 5 mm square.

"10,000 rectangular parallelepipeds" represents a heat dissipation structure in which 10,000 heat dissipation units 13 having a plate-shaped rectangular parallelepiped shape illustrated in Fig. 12 and having a length in the longitudinal direction x a length in the lateral direction x a height (the length of a protruding part) of 2 mm x 10 um x 100 µm are arranged on the back surface of the semiconductor device 201 of 5 mm square.

The surface area of the heat dissipation structure in the case where the heat dissipation units 13 are "10,000 pillars" is 1.3 times the surface area in the case of "Flat 30 um diameter, 100 pieces". The surface area of the heat dissipation structure in the case where the heat dissipation units 13 are "100,000 pillars" is 13 times the surface area in the case of "Flat 30 µm diameter, 100 pieces".

Furthermore, the surface area of the heat dissipation structure in the case where the heat dissipation units 13 are "1,000 rectangular parallelepipeds" is 7.2 times the surface area in the case of "Flat 30 um diameter, 100 pieces". The surface area of the heat dissipation structure in the case where the heat dissipation units 13 are "10,000 rectangular parallelepipeds" is 72.3 times the surface area in the case of "Flat 30 µm diameter, 100 pieces".

As described above, since the heat dissipation units 13 of the present embodiment each have a structure protruding from the insulating film 82 to be exposed, the heat dissipation surface area can be increased, and the heat dissipation efficiency can be improved. Needless to say, also in the structure of the heat dissipation units 13 in Figs. 13 to 15, the heat dissipation surface area can be increased, and the heat dissipation efficiency can be improved.

### <9. Configuration example of third embodiment>

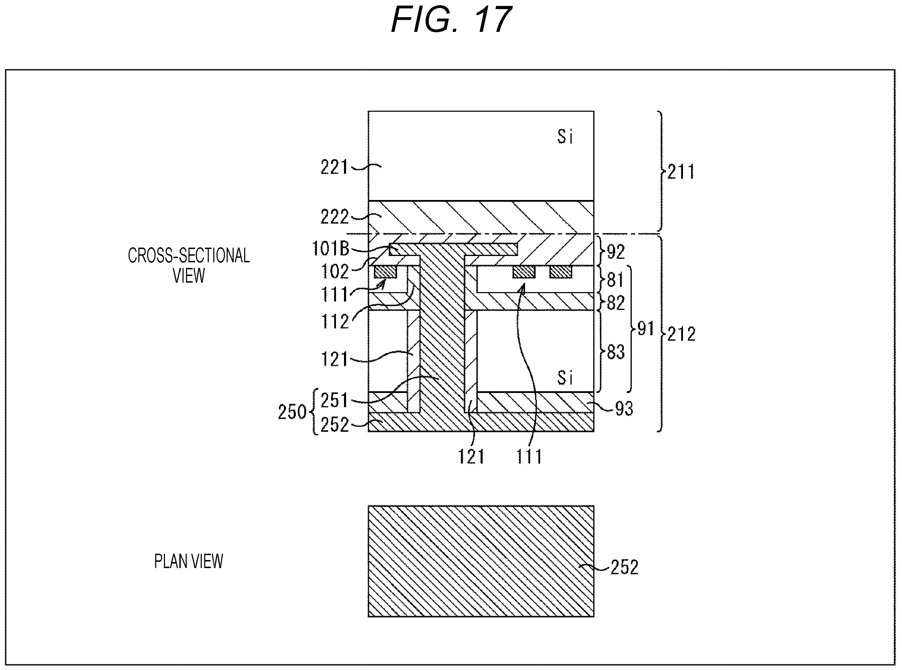

Fig. 17 is a cross-sectional view and a plan view of a main body of a semiconductor device as the third embodiment of the present disclosure.

Also in the third embodiment, parts common with the above-described second embodiment are denoted by the same reference numerals, and the description of the parts will be omitted as appropriate.

In the semiconductor device 201 of the second embodiment described above, the semiconductor substrate 83 of the SOI substrate 91 is removed, and the heat dissipation units 13 are formed so as to protrude from the insulating film 82 to be exposed as described with reference to Fig. 9 and the like.

In the third embodiment, a heat dissipation unit 250 is provided instead of the heat dissipation units 13 of the second embodiment.

More specifically, the main body 11 is formed by laminating a first circuit board 211 and a second circuit board 212. The first circuit board 211 is similar to that of the second embodiment described above.

The first circuit board 211 has a semiconductor substrate 221 and an insulating film 222, and is bonded to the second circuit board 212 via the insulating film 222 formed on the lower surface of the semiconductor substrate 221.

The second circuit board 212 is formed by laminating an SOI substrate 91 in which a semiconductor layer 81, an insulating film 82, and a semiconductor substrate 83 are laminated, and a wiring layer 92 including one or more layers of metal wiring 101 and an interlayer insulating film 102. An insulating film 93 is formed on the back surface side of the semiconductor substrate 83.

The heat dissipation unit 250 includes a through conductor unit 251 penetrating the SOI substrate 91, and a heat dissipation plate 252 formed on the insulating film 93 on the back surface side of the semiconductor substrate 83. The heat dissipation unit 250 is formed using the same metal material as the heat dissipation units 13, for example, copper.

In the third embodiment, the heat dissipation unit 250 includes the heat dissipation plate 252, and the heat dissipation surface area on the back surface side of the semiconductor device 201 is increased by the heat dissipation plate 252, thereby improving the heat dissipation efficiency.

The structure of the heat dissipation unit 250 of the third embodiment can be manufactured by carrying out the steps from A of Fig. 3 to C of Fig. 4 of the first embodiment with respect to the second circuit board 212.

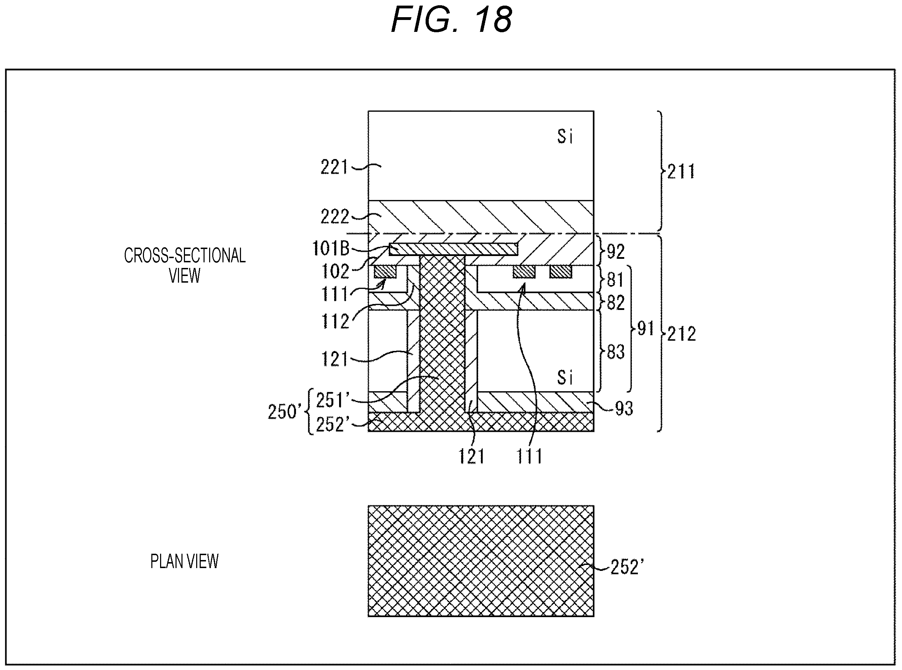

Fig. 18 illustrates a modification of the third embodiment of the present disclosure, and illustrates an example in which the heat dissipation unit 250 is changed to a heat dissipation unit 250' formed using a high thermal conductivity material.

Examples of the high thermal conductivity material used as the material of the heat dissipation unit 250' include diamond, diamond-like carbon, and the like. For example, copper has a thermal conductivity of approximately 397 W/m-K, and tungsten has a thermal conductivity of approximately 178 W/m-K, while diamond has a thermal conductivity of approximately 1000 to 2000 W/m·K.

High thermal conductivity materials such as diamond and diamond-like carbon can be applied not only to the third embodiment but also to the heat dissipation units 13 of the first and second embodiments described above.

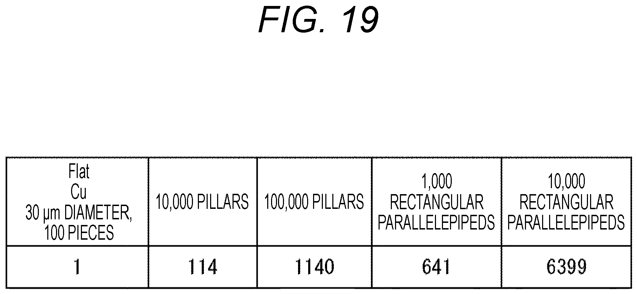

Fig. 19 is a table comparing heat dissipation efficiency in a case where diamond-like carbon, which is a high thermal conductivity material, is used for the heat dissipation units 13 of the second embodiment.

"Flat Cu, 30 um diameter, 100 pieces" represents a heat dissipation structure in which 100 circles having a diameter of 30 um are formed on the same plane as the insulating film 82 on the back surface of the semiconductor device 201 of 5 mm square and copper is embedded in the circles, and the heat dissipation efficiency in this case is used as a reference ("1").

The heat dissipation structures of "10,000 pillars", "100,000 pillars", "1,000 rectangular parallelepipeds", and "10,000 rectangular parallelepipeds" are similar to the structures described with reference to Fig. 16. However, they are different in that the material of the heat dissipation units 13 is not copper but diamond-like carbon.

The heat dissipation efficiency of the heat dissipation structure in the case where the heat dissipation units 13 are "10,000 pillars" is 114 times the heat dissipation efficiency in the case of "Flat Cu, 30 um diameter, 100 pieces".

The heat dissipation efficiency of the heat dissipation structure in the case where the heat dissipation units 13 are "100,000 pillars" is 1140 times the heat dissipation efficiency in the case of "Flat Cu, 30 um diameter, 100 pieces".

The heat dissipation efficiency of the heat dissipation structure in the case where the heat dissipation units 13 are "1,000 rectangular parallelepipeds" is 641 times the heat dissipation efficiency in the case of "Flat Cu, 30 um diameter, 100 pieces".

The heat dissipation efficiency of the heat dissipation structure in the case where the heat dissipation units 13 are "10,000 rectangular parallelepipeds" is 6399 times the heat dissipation efficiency in the case of "Flat Cu, 30 um diameter, 100 pieces".

As described above, by using a high thermal conductivity material such as diamond-like carbon as the material of the heat dissipation units 13, the heat dissipation efficiency can be further improved.

### <10. Example of application to electronic apparatus>

The technology of the present disclosure can be applied to general electronic apparatuses using a solid-state imaging device as an image capturing unit (a photoelectric conversion unit), such as an imaging device such as a digital still camera or a video camera, a mobile terminal device having an imaging function, and a copying machine using a solid-state imaging device as an image reading unit. The solid-state imaging device may be formed as one chip, or may be in a module form having an imaging function in which an imaging section and a signal processing unit or an optical system are packaged together.

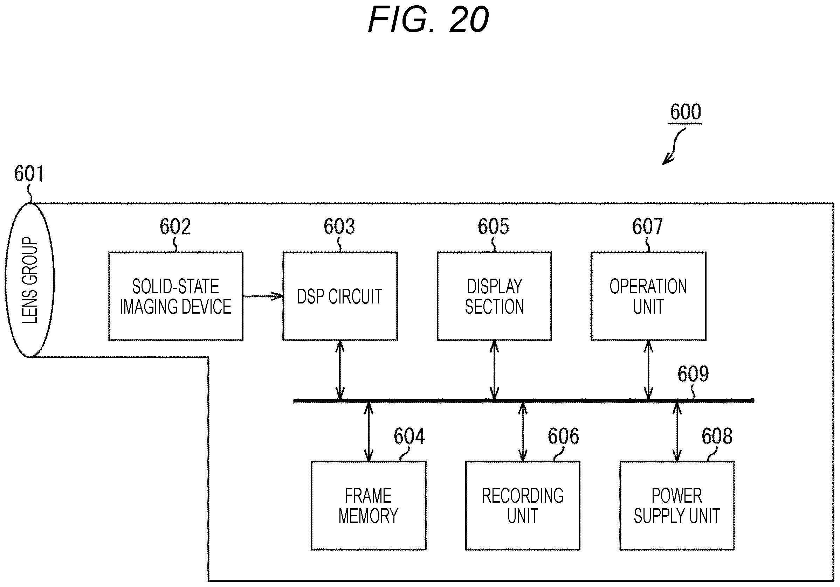

Fig. 20 is a block diagram illustrating a configuration example of an imaging device as an electronic apparatus to which the technology of the present disclosure is applied.

An imaging device 600 in Fig. 20 includes an optical unit 601 including a lens group and the like, a solid-state imaging device (imaging device) 602 in which the configuration of the solid-state imaging device 1 in Fig. 1 is adopted, and a digital signal processor (DSP) circuit 603 that is a camera signal processing circuit. Furthermore, the imaging device 600 also includes a frame memory 604, a display section 605, a recording unit 606, an operation unit 607, and a power supply unit 608. The DSP circuit 603, the frame memory 604, the display section 605, the recording unit 606, the operation unit 607, and the power supply unit 608 are connected with each other via a bus line 609.

The optical unit 601 captures incident light (image light) from a subject and forms an image on an imaging surface of the solid-state imaging device 602. The solid-state imaging device 602 converts the light amount of the incident light imaged on the imaging surface by the optical unit 601 into an electric signal in pixel units and outputs the electric signal as a pixel signal. Used as the solid-state imaging device 602 is the solid-state imaging device 1 in Fig. 1, that is, a solid-state imaging device including the heat dissipation units 13 that penetrate the semiconductor layer 81 and the insulating film 82 formed on the first surface of the semiconductor layer 81 and protrude from the insulating film 82 to be exposed.

The display section 605 includes, for example, a thin display such as a liquid crystal display (LCD) or an organic electro luminescence (EL) display, and displays a moving image or a still image captured by the solid-state imaging device 602. The recording unit 606 records the moving image or the still image captured by the solid-state imaging device 602 on a recording medium such as a hard disk or a semiconductor memory.

The operation unit 607 issues operation commands regarding various functions of the imaging device 600 under operation by the user. The power supply unit 608 supplies various power sources serving as operation power sources for the DSP circuit 603, the frame memory 604, the display section 605, the recording unit 606, and the operation unit 607 to these supply targets as appropriate.

As described above, by using the solid-state imaging device 1 including the plurality of heat dissipation units 13 as the solid-state imaging device 602, heat can be efficiently dissipated even in a case where the thermal density increases due to the increase in the number of pixels and the improvement in the degree of integration in a chip due to miniaturization. Accordingly, in the imaging device 600 such as a video camera, a digital still camera, or a camera module for a mobile device such as a mobile phone, a high-quality captured image can be acquired at high speed.

### <11. Usage example of image sensor>

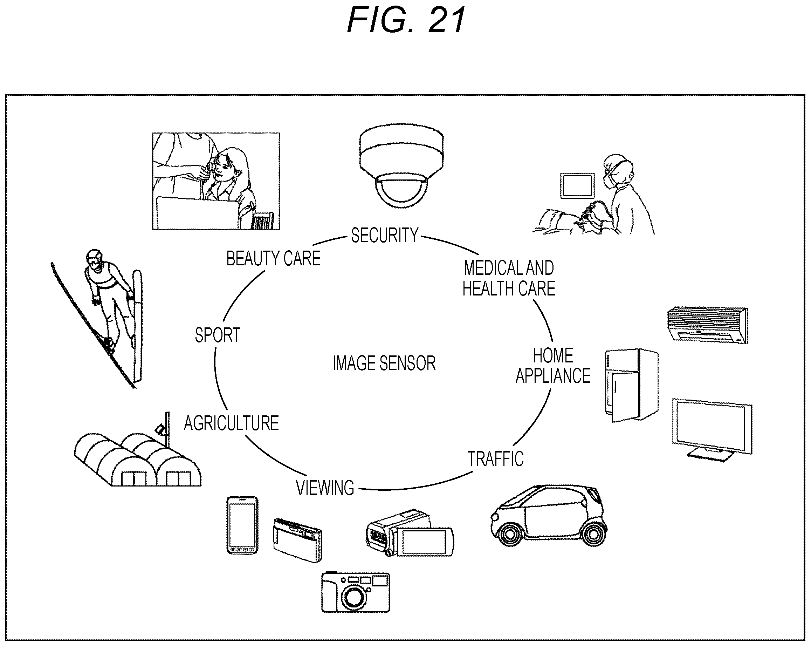

Fig. 21 is a diagram illustrating a usage example of an image sensor using the above-described solid-state imaging device 1.

The above-described solid-state imaging device 1 can be used as an image sensor in various cases of sensing light such as visible light, infrared light, ultraviolet light, and X-rays as described below, for example.

- A device that captures an image to be used for viewing, such as a digital camera and a portable device with a camera function.
- A device for traffic such as an in-vehicle sensor that images the front, rear, surroundings, interior and the like of an automobile, a monitoring camera that monitors traveling vehicles and roads, and a distance measuring sensor that measures a distance between vehicles and the like for safe driving such as automatic stop, recognition of a driver's condition, and the like
- A device for home appliance such as a television, a refrigerator, and an air conditioner that images a user's gesture and performs device operation according to the gesture
- A device for medical and health care use such as an endoscope or a device that performs angiography by receiving infrared light
- A device for security use such as a security monitoring camera or an individual authentication camera
- A device for beauty care, such as a skin measuring instrument for imaging skin, or a microscope for imaging the scalp
- A device for sport, such as an action camera or a wearable camera for sports applications or the like
- A device for agriculture, such as a camera for monitoring the condition of a field or crop.

### <12. Example of application to mobile body>

The technology according to the present disclosure (present technology) can be applied to various products. For example, the technology of the present disclosure may be implemented as a device mounted on any type of mobile body such as an automobile, an electric vehicle, a hybrid electric vehicle, a motorcycle, a bicycle, a personal mobility, an airplane, a drone, a ship, a robot, and the like.

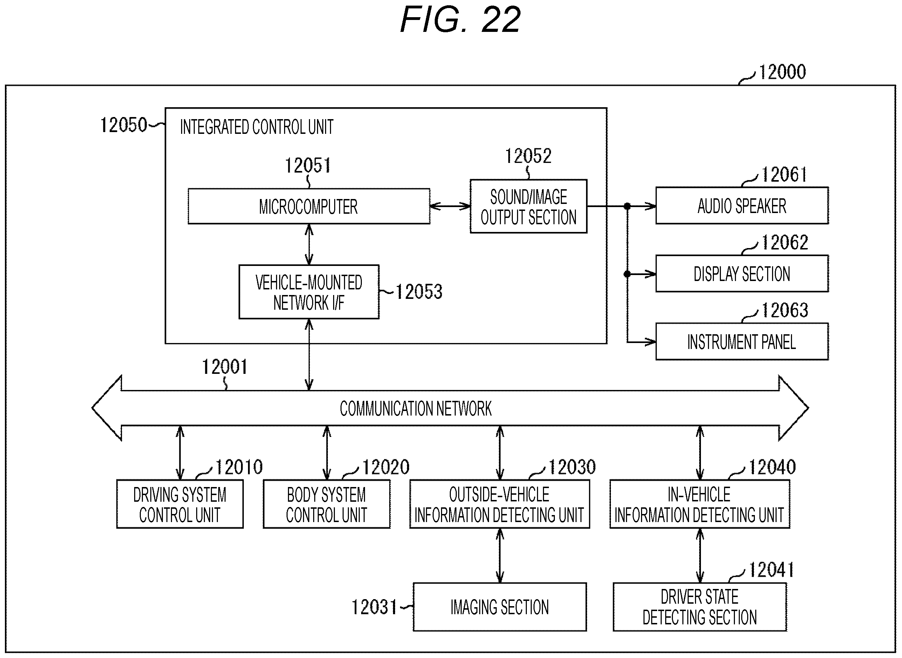

Fig. 22 is a block diagram illustrating a schematic configuration example of a vehicle control system which is an example of a mobile body control system to which the technology according to the present disclosure can be applied.

The vehicle control system 12000 includes a plurality of electronic control units connected to each other via a communication network 12001. In the example illustrated in Fig. 22, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12020 on the basis of the information about the outside of the vehicle which information is acquired by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 22, an audio speaker 12061, a display section 12062, and an instrument panel 12063 are illustrated as output devices. The display section 12062 may, for example, include at least one of an on-board display and a head-up display.

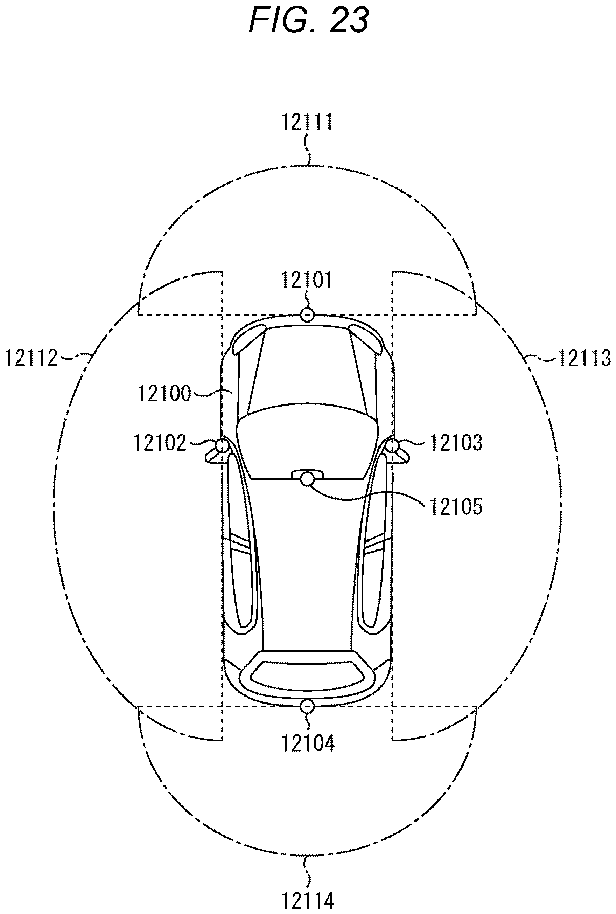

Fig. 23 is a view illustrating an example of an installation position of the imaging section 12031.

In Fig. 23, a vehicle 12100 has imaging sections 12101, 12102, 12103, 12104, and 12105 as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle, and the like. The imaging section 12101 provided to the front nose and the imaging section 12105 provided to the upper portion of the windshield within the interior of the vehicle obtain mainly an image of the front of the vehicle 12100. The imaging sections 12102 and 12103 provided at the side mirrors mainly acquire images of the sides of the vehicle 12100. The imaging section 12104 provided to the rear bumper or the back door obtains mainly an image of the rear of the vehicle 12100. The front images acquired by the imaging sections 12101 and 12105 are used mainly to detect a preceding vehicle, a pedestrian, an obstacle, a traffic signal, a traffic sign, a lane, or the like.

Note that Fig. 23 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of a vehicle control system to which the technology according to the present disclosure can be applied has been described above. The technology according to the present disclosure can be applied to the imaging section 12031 in the configurations described above. Specifically, the solid-state imaging device 1 including the heat dissipation units 13 described above can be applied as the imaging section 12031. By applying the technology according to the present disclosure to the imaging section 12031, it is possible to obtain a more easily viewable captured image with excellent heat dissipation efficiency while reducing the size, and to acquire distance information. Furthermore, it is possible to reduce driver's fatigue and increase the safety of the driver and the vehicle by using the captured image and distance information that is obtained.

The technology of the present disclosure is not limited to application to a solid-state imaging device that detects distribution of the amount of incident light of visible light and captures the distribution as an image, and can be applied to general solid-state imaging devices (physical quantity distribution detection devices) such as a solid-state imaging device that captures distribution of the amount of incident infrared rays, X-rays, particles, or the like as an image, and a fingerprint detection sensor that detects distribution of other physical quantities such as pressure and capacitance and captures the distribution as an image in a broad sense.

Furthermore, the technology of the present disclosure can be applied not only to solid-state imaging devices but also to general semiconductor devices having other semiconductor integrated circuits.

Embodiments of the present disclosure are not limited to the above embodiments, and various modifications may be made without departing from the scope of the technology of the present disclosure.

The effects described in the present specification are merely examples and are not limited, and effects other than those described in the present specification may be provided.

Note that the technique of the present disclosure can have the following configurations.
(1) A semiconductor device including
   a heat dissipation unit that penetrates a semiconductor layer and an insulating film formed on a first surface side of the semiconductor layer and protrudes from the insulating film to be exposed.
(2) The semiconductor device according to (1) described above,
   in which the heat dissipation unit is isolated from the semiconductor layer by an element isolation region.
(3) The semiconductor device according to (1) or (2) described above,
   in which the heat dissipation unit is connected with a predetermined metal wiring of a wiring layer formed on a second surface side opposite to the first surface side of the semiconductor layer.
(4) The semiconductor device according to any one of (1) to (3) described above,
   in which an element is formed in the semiconductor layer.
(5) The semiconductor device according to any one of (1) to (4) described above, further including
   a through electrode that has a same length as a length of the heat dissipation unit and penetrates the semiconductor layer and the insulating film.
(6) The semiconductor device according to (5) described above,
   in which the through electrode is connected with an electrode that is an external terminal.
(7) The semiconductor device according to (5) or (6) described above,
   in which the through electrode penetrates a semiconductor substrate in addition to the semiconductor layer and the insulating film, and
   the insulating film is an intermediate layer between the semiconductor layer and the semiconductor substrate.
(8) The semiconductor device according to (7) described above,
   in which the heat dissipation unit protrudes from the insulating film to be exposed by a thickness equal to or larger than a thickness of the semiconductor substrate.
(9) The semiconductor device according to (7) or (8) described above,
   in which a semiconductor material of the semiconductor substrate is silicon.
(10) The semiconductor device according to any one of (1) to (9) described above,
   in which a material of the heat dissipation unit is any of a metal material, diamond, and diamond-like carbon.
(11) The semiconductor device according to any one of (1) to (10) described above,
   in which the semiconductor layer is a silicon layer.
(12) The semiconductor device according to any one of (1) to (11) described above,
   in which the insulating film is a silicon oxide film.
(13) The semiconductor device according to any one of (1) to (12) described above, further including
   a plurality of the heat dissipation units,
   in which a three-dimensional shape of the heat dissipation unit is a pillar shape.
(14) The semiconductor device according to any one of (1) to (12) described above, further including
   a plurality of the heat dissipation units,
   in which a three-dimensional shape of the heat dissipation unit is a rectangular parallelepiped.
(15) The semiconductor device according to any one of (1) to (12) described above,
   in which a three-dimensional shape of the heat dissipation unit is a structure in which a plate-shaped rectangular parallelepiped elongated in a longitudinal direction and a plate-shaped rectangular parallelepiped elongated in a lateral direction in plan view are combined.
(16) The semiconductor device according to any one of (1) to (15) described above, further including:
   a first substrate including a pixel array unit in which pixels each having a photoelectric conversion unit are arranged in a matrix; and
   a second substrate in which the semiconductor layer and the insulating film are laminated on a semiconductor substrate,
   the first substrate and the second substrate being laminated to form the semiconductor device.
(17) A method of manufacturing a semiconductor device, the method including
   forming a heat dissipation unit that penetrates a semiconductor layer and an insulating film formed on a first surface side of the semiconductor layer and protrudes from the insulating film to be exposed.
(18) An electronic apparatus including
   a semiconductor device including a heat dissipation unit that penetrates a semiconductor layer and an insulating film formed on a first surface side of the semiconductor layer and protrudes from the insulating film to be exposed.

### REFERENCE SIGNS LIST

- 1: Solid-state imaging device
- 2: Interposer substrate
- 11: Main body
- 12: Through electrode
- 13: Heat dissipation unit
- 14: Electrode unit
- 31: Through electrode region
- 32: Heat dissipation unit region
- 51: CIS substrate
- 52: Logic substrate
- 53: Sealing resin
- 54: Glass protective substrate
- 71: Semiconductor substrate
- 72: Color filter layer
- 73: Insulating film
- 81: Semiconductor layer
- 82: Insulating film
- 83: Semiconductor substrate
- 91: SOI substrate
- 92: Wiring layer
- 93: Insulating film
- 101(101A, 101B): Wiring
- 102: Interlayer insulating film
- 111: Element
- 112: Element isolation region
- 121: Insulating film
- 201: Semiconductor device
- 211: First circuit board
- 212: Second circuit board
- 221: Semiconductor substrate
- 222: Insulating film
- 250: Heat dissipation unit
- 251: Through conductor unit
- 252: Heat dissipation plate
- 600: Imaging device
- 602: Solid-state imaging device

## Claims

1. A semiconductor device comprising
a heat dissipation unit that penetrates a semiconductor layer and an insulating film formed on a first surface side of the semiconductor layer and protrudes from the insulating film to be exposed.

2. The semiconductor device according to claim 1,
wherein the heat dissipation unit is isolated from the semiconductor layer by an element isolation region.

3. The semiconductor device according to claim 1,
wherein the heat dissipation unit is connected with a predetermined metal wiring of a wiring layer formed on a second surface side opposite to the first surface side of the semiconductor layer.

4. The semiconductor device according to claim 1,
wherein an element is formed in the semiconductor layer.

5. The semiconductor device according to claim 1, further comprising
a through electrode that has a same length as a length of the heat dissipation unit and penetrates the semiconductor layer and the insulating film.

6. The semiconductor device according to claim 5,
wherein the through electrode is connected with an electrode that is an external terminal.

7. The semiconductor device according to claim 5,
wherein the through electrode penetrates a semiconductor substrate in addition to the semiconductor layer and the insulating film, and
the insulating film is an intermediate layer between the semiconductor layer and the semiconductor substrate.

8. The semiconductor device according to claim 7,
wherein the heat dissipation unit protrudes from the insulating film to be exposed by a thickness equal to or larger than a thickness of the semiconductor substrate.

9. The semiconductor device according to claim 7,
wherein a semiconductor material of the semiconductor substrate is silicon.

10. The semiconductor device according to claim 1,
wherein a material of the heat dissipation unit is any of a metal material, diamond, and diamond-like carbon.

11. The semiconductor device according to claim 1,
wherein the semiconductor layer is a silicon layer.

12. The semiconductor device according to claim 1,
wherein the insulating film is a silicon oxide film.

13. The semiconductor device according to claim 1, further comprising
a plurality of the heat dissipation units,
wherein a three-dimensional shape of the heat dissipation unit is a pillar shape.

14. The semiconductor device according to claim 1, further comprising
a plurality of the heat dissipation units,
wherein a three-dimensional shape of the heat dissipation unit is a rectangular parallelepiped.

15. The semiconductor device according to claim 1,
wherein a three-dimensional shape of the heat dissipation unit is a structure in which a plate-shaped rectangular parallelepiped elongated in a longitudinal direction and a plate-shaped rectangular parallelepiped elongated in a lateral direction in plan view are combined.

16. The semiconductor device according to claim 1, further comprising:
a first substrate including a pixel array unit in which pixels each having a photoelectric conversion unit are arranged in a matrix; and
a second substrate in which the semiconductor layer and the insulating film are laminated on a semiconductor substrate,
the first substrate and the second substrate being laminated to form the semiconductor device.

17. A method of manufacturing a semiconductor device, the method comprising
forming a heat dissipation unit that penetrates a semiconductor layer and an insulating film formed on a first surface side of the semiconductor layer and protrudes from the insulating film to be exposed.

18. An electronic apparatus comprising
a semiconductor device including a heat dissipation unit that penetrates a semiconductor layer and an insulating film formed on a first surface side of the semiconductor layer and protrudes from the insulating film to be exposed.
